# EUROPEAN PATENT APPLICATION

(11) **EP 2 479 789 A2**
(43) Date of publication of application: **25.07.2012**
(21) Application number: 11190197.1
(22) Date of filing: 22.11.2011
(51) Int. Cl.: H01L 27/142, H01L 31/0232, H01L 31/055

(54) **Photovoltaic device and method for making**

(30) Priority: 30.11.2010 US 956811
(71) Applicant: General Electric Company, Schenectady, NY 12345 (US)
(72) Inventor: Sulima, Oleg, Niskayuna, NY 12309 (US); Tsakalakos, Loucas, Niskayuna, NY 12309 (US); Wei, Ching-Yeu, Niskayuna, NY 12309 (US); Srivastava, Alok Mani, Niskayuna, NY 12309 (US); Halverson, Adam Fraser, Niskayuna, NY 12309 (US)
(74) Representative: Bedford, Grant Richard

(57) **Abstract**

An article (10), such as a solar cell or module, is presented. In one embodiment, the article (10) includes a photovoltaically active region (20) and a photovoltaically inactive region (30). A filler material (40) is disposed in the inactive region (30); the filler material (40) includes a reflective material configured to scatter at least 50% of light incident on the filler material (40). Another embodiment is an article (10) that includes a photovoltaically active region (20) and a photovoltaically inactive region (30). A filler material (40) is disposed in the inactive region (30); the filler material (40) includes a wavelength converting material. Other embodiments are described herein in which the filler material (40) described above and disposed in the inactive region (30) includes both the reflective material and the wavelength converting material.

## Description

This invention relates generally to photovoltaic devices. More particularly, this invention relates to devices that incorporate engineered materials designed to enhance a device's ability to capture and convert light that is typically lost in conventional designs.

One of the main focuses in the field of photovoltaic devices is the improvement of energy conversion efficiency (from electromagnetic energy to electric energy or vice versa). The devices often suffer reduced performance due to loss of light. Therefore, research in optical designs of these devices includes light collection and trapping, spectrally matched absorption, and up/down light energy conversion.

In particular, certain regions of photovoltaic devices are typically void of photovoltaically active materials, that is, materials that are able to absorb light and convert it to electricity. Thus even comparatively high-efficiency devices by today's standards may include photovoltaically inactive areas--areas that fail to harvest light for energy conversion.

Therefore, there remains a need in the art for photovoltaic devices with enhanced efficiency, including the ability to capture and convert at least some of the light that is typically lost to photovoltaically inactive areas.

Various embodiments of the present invention are provided to address these and other needs. One embodiment is an article. The article includes a photovoltaically active region and a photovoltaically inactive region. A filler material is disposed in the inactive region; the filler material includes a reflective material configured to scatter at least 50% of light incident on the filler material.

Another embodiment is an article that includes a photovoltaically active region and a photovoltaically inactive region. A filler material is disposed in the inactive region; the filler material includes a wavelength converting material.

Other embodiments are described herein in which the filler material described above and disposed in the inactive region includes both the reflective material and the wavelength converting material.

Various features, aspects, and advantages of the present invention will become better understood when the following detailed description is read with reference to the accompanying drawings, wherein:

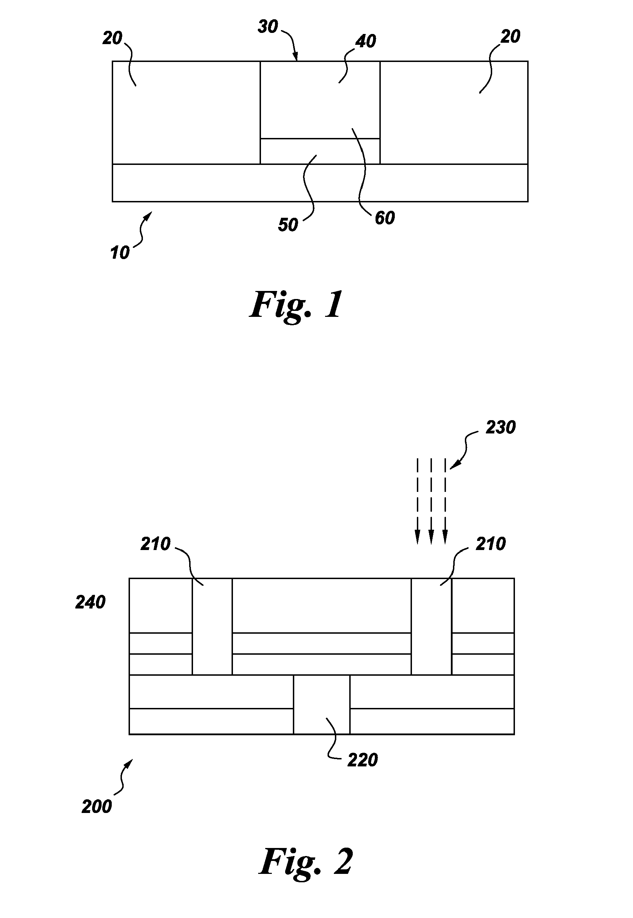

FIG. 1-4 are schematic illustrations of various photovoltaic devices, in accordance with embodiments of the present invention.

As discussed in detail below, embodiments of the present invention include an article having a photovoltaically active region and a photovoltaically inactive region. A photovoltaically active region, as that term is used herein, means a region of the article that includes a material that exhibits the well-known photovoltaic effect, that is, the creation of a voltage ("photovoltage") and/or a corresponding electric current "photocurrent") when exposed to electromagnetic radiation, typically radiation in the visible and near visible wavelengths. A photovoltaically inactive region, as that term is used herein, means a region of the article that lacks such a material, or is situated such that the region lacks access to incident light, and therefore is not directly used to any practical extent for generation of electrical current.

Various embodiments of the present invention may further include a filler material disposed in the inactive region or regions of the article. The filler material may have certain characteristics that render the inactive regions useful in enhancing the ability of the article, typically a photovoltaic device, to collect light and convert it to electric current. For example, the filler material may include a reflective material that redirects at least some of the light incident on the inactive regions to the active regions, where the otherwise unused light may be applied toward power generation. In another example, the filler material may include a wavelength converting material, which absorbs incident light of certain wavelengths and, in response, emits light of different wavelengths. The absorption and emission of the material may be tailored so that the emission is in a part of the spectrum that is well suited for use by the photovoltaic material in the active region of the article for efficient conversion. In one embodiment, the filler material includes both reflective material and wavelength converting material. Moreover, in some embodiments, the filler material (whether the filler includes reflective material, wavelength converting material, or both of these) further includes material that may passivate adjacent interfacial material in the active region, which may reduce inefficiencies associated with electron-hole recombination. In short, embodiments of the present invention include filler materials, disposed in otherwise inactive regions, that may enhance overall utilization of incident light, boosting photovoltaic device efficiency compared with devices that do not include such filler materials.

Approximating language, as used herein throughout the specification and claims, may be applied to modify any quantitative representation that could permissibly vary without resulting in a change in the basic function to which it is related. Accordingly, a value modified by a term or terms, such as "about", is not limited to the precise value specified. In some instances, the approximating language may correspond to the precision of an instrument for measuring the value.

In the following specification and the claims, the singular forms "a", "an" and "the" include plural referents unless the context clearly dictates otherwise. Thus where embodiments are described as including "a" or "an" object, it should be understood that the embodiment includes at least one of the described objects.

As used herein, the terms "may" and "may be" indicate a possibility of an occurrence within a set of circumstances; a possession of a specified property, characteristic or function; and/or qualify another verb by expressing one or more of an ability, capability, or possibility associated with the qualified verb. Accordingly, usage of "may" and "may be" indicates that a modified term is apparently appropriate, capable, or suitable for an indicated capacity, function, or usage, while taking into account that in some circumstances the modified term may sometimes not be appropriate, capable, or suitable. For example, in some circumstances, an event or capacity can be expected, while in other circumstances the event or capacity cannot occur - this distinction is captured by the terms "may" and "may be".

The term "transparent", as used herein, means that a layer of a material allow the passage of a substantial portion of incident solar radiation. The substantial portion may be at least about 80% of the incident solar radiation.

Referring to Figure 1, one embodiment of the present invention is an article 10. Article 10 may be a photovoltaic cell such as a single junction or a multi-junction photovoltaic cell, for example, or may be a photovoltaic module that includes multiple cells. Article 10 includes a photovoltaically active region 20. Active region 20 typically includes an absorber material that exhibits the photovoltaic effect, and it is common in the art to name a type of cell based on the absorber material used by that cell. Accordingly, non-limiting examples of photovoltaic cells include an amorphous silicon cell, a crystalline silicon cell, a hybrid/heterojunction amorphous and crystalline silicon cell, a micromorph tandem silicon thin film cell, a cadmium telluride (CdTe) thin film cell, a Cu(In,Ga,Al)(Se,S)₂ (also referred to as "CIGS") thin film cell, a copper-zinc-tin-sulfide (CZTS) thin film cell, a metal sulfide thin film cell, a metal phosphide thin film cell, a GaAs cell, a multiple-junction III-V-based solar cell, or a solid-state organic/polymer solar cell.

Article 10 further includes a photovoltaically inactive region 30. Inactive region 30 lacks an absorber material and/or access to incident light and thus does not participate directly in converting incident light into electrical power. Some examples of an inactive region in photovoltaic cells include laser scribe lines, generally used, for instance, in monolithically integrated thin-film photovoltaic modules to create separate photovoltaic cells; edges of cells and modules, which often lack absorber layers; and gaps between cells, for instance in a silicon-based module or other module that is not monolithically integrated. A further example of an inactive region 30 is the front contact grid commonly used in silicon-based solar cells. The grid is generally made up of current carriers, such as fine wires or other conductors, that produce shadows on neighboring areas, reducing the available effective area for electricity production.

In conventional photovoltaic technology, such inactive areas are typically filled or coated, if at all, with an insulating material that has little or no substantive optical functionality. Thus such areas represent a pure loss in device efficiency. However, in embodiments of the present invention, a filler material 40 is disposed in inactive region 30, and this filler material 40 has one or more functions that may help to boost efficiency of article 10. Where inactive region 30 includes a surface, such as a front contact grid component (not shown), the filler material may be disposed on the surface, such as where filler material 40 is coated onto a conductor or other front contact grid component. Thus, although many of the examples and discussion herein describe embodiments where filler material 40 is filling in void spaces, it will be appreciated that these descriptions are not limiting, and embodiments where filler material 40 is disposed on surfaces like grid conductors are contemplated and included where the filler 40 is described as being disposed "in" inactive region 30.

In one embodiment, filler material 40 includes a reflective material. The reflective material is configured via selection of composition and/or structure, to scatter at least 50%, and in some embodiments, at least 80%, of light incident on filler material 40. Generally, incident light is scattered by the reflective material with no particular directionality, but at least a portion of the reflected light is directed onto active region 20 as additional light available for conversion to energy. In one embodiment, the reflective material includes a plurality of scattering centers disposed in a matrix. Generally, the scattering centers are present in the matrix at a sufficiently high concentration to achieve the reflectivity level desired for a particular application. In some embodiments, this concentration is in the range from about 10 volume percent to about 75 volume percent, and in certain embodiments is in the range from about 50 volume percent to about 70 volume percent.

In some embodiments, the scattering centers include a plurality of voids. Voids, in some embodiments, have a median size up to 1 micrometer, and in particular embodiments the median void size in the material is up to 500 nanometers.

In some embodiments, the scattering centers include particles. The particles may be hollow, porous, or solid, and can include any of a variety of shapes, such as, but not limited to, spherical, lenticular, rod-like, and plate-like. In some embodiments, the plurality of particles has a median size of up to 10 micrometers, and in particular embodiments, the median size is in the range from about 200 nanometers to about 1000 nanometers. In some embodiments, the particles comprise an inorganic material, such as an oxide. Examples of suitable oxides include, but are not limited to, oxides of one or more of the following materials: titanium, aluminum, silicon, hafnium, zirconium, and combinations that include at least one of the foregoing.

The reflective property of a material made up of particles and/or voids distributed in a matrix is controlled in large part by the nature of the interfaces between these scattering centers and the matrix material. In particular, the difference between the index of refraction of the matrix and the index of refraction of the material making up the scattering center has a significant effect on the nature of how incident light behaves upon encountering the interface. Generally, reflection is favored for larger differences in refractive index. Thus, in some embodiments, the difference between the index of refraction of the matrix and the index of refraction of the scattering centers is at least 0.01, and in particular embodiments, this difference is at least 0.5. Thus the selection of the matrix material and the scattering center material may be interdependent. Examples of matrix materials include, but are not limited to, a glass, a polymer, or hybrid organic-inorganic materials. Examples of this last class of materials include, without limitation fumed silica nanoparticles dispersed in a polymer, or spin-on glass type materials generally made of siloxane or silsesquioxane chemistries with residual organic content such as methyl and/or phenyl groups.

Filler material 40, in some embodiments, comprises a wavelength converting material. Wavelength converting material, in some embodiments, is present in addition to any of the reflective materials described above. In alternative embodiments, filler material 40 contains wavelength converting material without further additions of the above reflective material.

The wavelength-converting material may absorb radiation of a particular wavelength, or a particular range of wavelengths, while not scattering the radiation. The material may absorb radiation from UV, to visible, to near infrared, to infrared, and if the absorbed radiation is of sufficient energy to excite the material, the material then emits radiation of a different wavelength, thus converting the absorbed radiation to usable radiation. The term "usable radiation" as used herein, refers to photons of a particular wavelength, or a particular range of wavelengths, that takes part in energy conversion in the photovoltaically active region 20 of article 10 with desirable internal and external quantum efficiency. That is, the probability of collecting an electron-hole pair in that emitted spectral range is high (called herein a "high efficiency region" of the spectrum with respect to active region 20), usually greater than about 50%, and often greater than about 70%. Thus, the wavelength-converting material emits such photons that can be absorbed by an absorber material of the device to produce an electron-hole pair. Conversely, a "low efficiency region" of the spectrum as used herein in reference to active region 20, refers to wavelengths for which the aforementioned probability is below 50%, and often below 20%. It will be noted that the "high efficiency region" and the "low efficiency region," though used herein in reference to active region 20 of article 10, are dependent on both the nature of the absorber material and its combination with other layers in article 10, and thus these regions may well vary for a given absorber material depending on the overall device design and material selection. Nevertheless, one skilled in the art may readily determine high and low efficiency spectral regions for a given cell design and apply that information as used herein.

The wavelength converting material has an "excitation region" that is defined as that portion of the electromagnetic spectrum where the wavelength conversion material absorbs at least 5% of incident radiation. Furthermore, in response to absorbing radiation within the excitation region, the wavelength conversion material emits radiation in accordance with an emission spectrum. The wavelengths that fall within the emission spectrum are referred to herein as the "emission region" of the wavelength conversion material. In some embodiments, the excitation region of the wavelength conversion material overlaps, that is, shares some common wavelengths with, the low efficiency region of active region 20. In certain embodiments, the emission region of the wavelength material overlaps the high efficiency region of active region 20. In particular embodiments, both of these conditions are met, such that the wavelength conversion material absorbs at least some wavelengths not readily converted to electricity by the active region 20, and emits at least some wavelengths that are more easily converted by the active region 20.

As an example of the above, an absorber material in active region 20 may be CdTe; typical configurations of solar devices using this material often have relatively low efficiency of electron-hole collection for wavelengths less than about 500 nm but relatively high efficiency of electron-hole collection for wavelengths from about 500 nm to about 800 nm. Thus, in some embodiments, the wavelength conversion material has an excitation region that includes (but is not limited to) one or more wavelengths of light less than about 600 nm, such as, for instance, light having wavelengths less than about 500nm, and an emission region that includes (but is not limited to) one or more of the wavelengths of light in the range from about 500nm, and in some instances, from about 550 nm, to about 850 nm.

In some embodiments, the wavelength converting material includes a matrix material in which particles are disposed. Typically, the particles have the wavelength converting functionality, though this arrangement is strictly not necessary. In some embodiments, the particles comprise quantum-confined materials, such as a quantum dot, a nanotube, or a nanowires, for example. However, depending on the composition of the particles, larger particles may be used. In certain embodiments, the particles have a median size up to 10 micrometers, and in particular embodiments the median size of the particles is in the range from about 200 nanometers to about 1000 nanometers. Generally, the size and composition of the particles is selected to reduce reflectance and enhance absorption in the excitation region, so that available incident radiation can be absorbed and re-emitted as useable radiation. The particles may have shapes as described previously for the reflective materials. Furthermore, the loading of the particles in the matrix is typically controlled to provide the desired level of emission while maintaining physical properties of the filler material 40 to allow practical handling and use in the manufacturing process for article 10, typically up to about 60% weight loading in solution.

In some embodiments, the wavelength converting material includes luminescent phosphor type materials. Examples of such materials include certain oxides, fluorides, phosphides, and oxynitrides. Moreover, certain luminescent ions may be included as dopants, including ions such as erbium, samarium, manganese, cerium, or europium. Wavelength converting materials useful in embodiments of the present invention include both "upconverting materials" (materials that absorb low-energy photons and emit photons of higher energy) and "downconverting materials" (materials that absorb high-energy photons and emit photons of lower energy). Examples of upconverting materials include lanthanide-doped fluorides, such as NaYF₄ and Na(Gd,Y)F₄ ,to which lanthanide dopants may be added. Downconverting materials include the materials described in commonly owned U.S. Patent Application Nos. 12/894,901; 12/894,916; and 12/894,926, each of which is incorporated by reference herein. In particular embodiments the wavelength converting material includes barium aluminum fluoride that is doped with samarium ions, or aluminum oxide doped with chromium ions.

In particular embodiments, multiple inactive regions exist, and upconverting materials may be disposed in one inactive region and downconverting materials disposed in another region. In some embodiments having more than one inactive region, the filler material disposed in at least one of the inactive regions further includes an upconverting material, and the filler material disposed in at least one of the inactive regions further comprises a downconverting material. For example, in the embodiment illustrated in Figure 2, device 200 includes upper inactive regions 210 and lower inactive region 220. Upper inactive regions 210 are closer to incident radiation 230 than lower inactive region 220, and intervening layers 240 may absorb higher energy wavelengths while allowing lower energy wavelengths to pass through. Thus, in this example, the need for downconversion is greater in upper regions 210—where higher energy photons are more likely to be available—while the need for upconversion is greater in lower region 220, where lower energy photons are likely to predominate. Upper regions 210 thus may include a filler material that includes a downconverting material, while lower region 220 may include a filler material that includes an upconverting material. Of course, different cell designs may call for different placement of upconverting and down converting materials, and various mixtures of up-and down-converting materials may be employed in any given inactive region 210, 220.

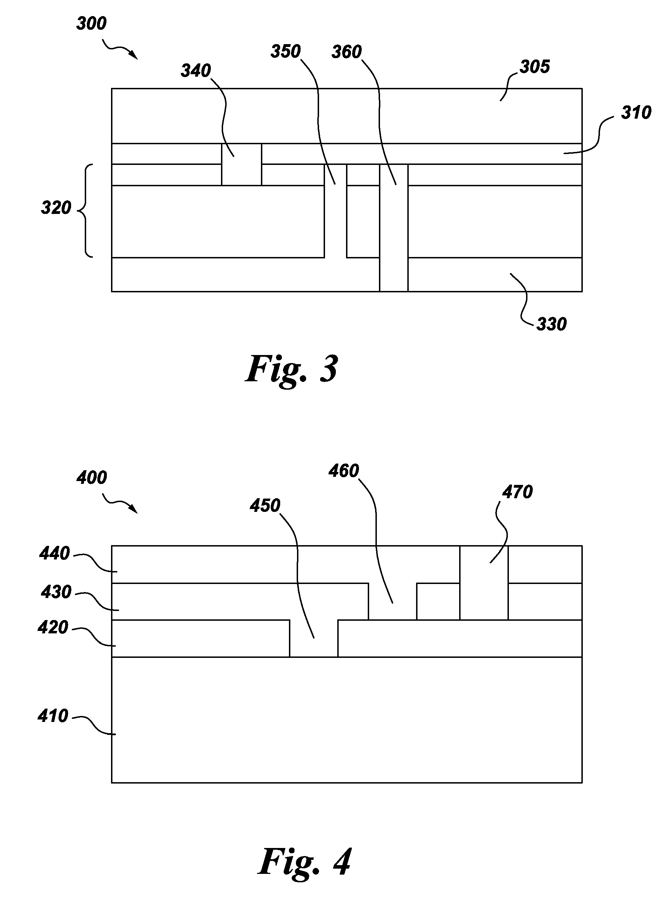

Figure 3 illustrates a typical monolithically integrated thin film solar module 300, which includes a transparent superstrate 305, a front contact layer 310 (such as a transparent conductive oxide or "TCO" layer), photovoltaic material 320 (typically including a semiconductor junction formed by multiple layers, such as a cadmium telluride absorber layer and a "cadmium sulfide window layer") and a back contact layer 330 (typically a metal or other conductor). Generally such a configuration includes three different types of scribe lines. The first scribe line 340, generally referred to in the art as "P1," patterns front contact 310; second scribe line 350, generally referred to in the art as "P2," patterns the photovoltaic material 320, and the third scribe line, generally referred to in the art as "P3," patterns the back contact 330. P1, P2, and P3 create inactive regions in the module, as described previously, and any one or combination of these scribe lines may include filler material 40 (Figure 1) to enhance performance. In certain embodiments, filler material 40 is disposed in P1 and P3, while P2 is filled with conductive material, such as the back contact metal.

Figure 4 illustrates a typical substrate configured module 400, which generally includes a substrate 410, back contact 420, photovoltaic material 430, and front contact 440. Here, the P1 scribe line 450 patterns back contact 420, the P2 scribe line 460 patterns the photovoltaic material 430, and the P3 scribe line 470 patterns the front contact 440. Again, any one or combination of P1, P2, and P3 may include filler material 40 (Figure 1), and in certain embodiments device 400 includes filler material 40 (Figure 1) in at least P3 scribe line 470. In certain embodiments, filler material 40 is disposed on top of front contact 440 in the region above the P1 and P2 scribe lines.

The matrix material used for the wavelength converting may be selected from among the same types of materials described above for matrix materials used for the reflective material: a glass, a polymer, or hybrid organic-inorganic materials, such as fumed silica nanoparticles dispersed in a polymer or spin-on glass type materials generally made of siloxane or silsesquioxane chemistries with residual organic content such as methyl and/or phenyl groups.

In some embodiments, where filler material 40 includes both reflective and wavelength converting materials, one matrix material is employed in which the scattering centers and the wavelength-converting particles are disposed. In other embodiments, filler material 40 includes discrete regions, such as layers, of reflective material and wavelength converting material, respectively, in which embodiments, of course, the matrix material of the respective regions may be identical or different from each other. In certain embodiments, filler material 40 includes a diffuse reflecting layer 50 (Figure 1) such as a layer of white paint, disposed behind (i.e. on a side opposite of the side first receiving incident light) an upper layer 60, to assist in reflection of incoming and converted radiation into an active region 20 and/or upper layer 60. Upper layer 60 of filler material 40 typically comprises a wavelength converting material.

As described above, filler material 40 may further include a passivating agent. A passivating agent is a material that removes sites in the absorber material, typically at interfacial regions, that promote electron-hole recombination and thereby reduce the overall photovoltaic efficiency of article 10. Sites that promote recombination include various imperfections, such as dangling chemical bonds at the material surface, dislocations, and other crystal defects. The passivating agent migrates to such places and binds with dangling bonds, thereby reducing the number of places where undesirable recombination may occur. Examples of passivating agents include certain sulfides and halide compounds, such as, for instance, ammonium sulfide and cadmium chloride. The agent may be included in filler material 40 at a concentration in the range from about 5 to about 100% by weight. In some embodiments, the photons generated by filler material 40 provide additional passivation of scribed sidewalls by filling trap states with photo-excited carriers. Saturation of defects at such surfaces may result in reduction of leakage currents, as well as improvement of minority carrier lifetime, open-circuit voltage, and fill factor of a device such as article 10.

Filler material 40 may be fabricated and disposed on inactive regions 30 of article 10 by any of various methods known in the art. For example, a paste that includes particles and matrix material (or a precursor to matrix material) may be formed and applied to inactive regions 30 using ink jet printing, screen printing, micro-jet printing, or other processes commonly used to dispose such materials in desired areas. A cure step, such as, for example, a thermal treatment, may be used to remove liquid-based carriers, such as water or non-aqueous solvent; the curing may also be applied to convert precursor materials to final form, such as glass or polymer, for instance.

### EXAMPLES

The descriptions below are intended to further illustrate certain embodiments of the present invention, and should not be understood as limiting the scope of various embodiments described previously.

Solar photoelectric devices were fabricated using cadmium telluride absorber material. Photovoltaically inactive areas were created, in some instances, by wet-etching in a patterned manner to create mesas of active area separated by inactive area, and in other instances by mechanically scribing to remove active materials from inactive regions. Various filler materials were created using barium aluminum fluoride doped with samarium ions as wavelength converting (downconverting, in this instance) material and a matrix of spin-on glass. The fluoride material was in particulate form, having a mean particle size of about 1 micrometer in one instance, and about 5 micrometers in another instance. Three different concentrations of the fluoride particles were tested— 22%, 40%, and 60% by weight. The particles were mixed with the spin-on glass precursor solution, and the mixture was painted into the inactive areas of the devices and cured by heating at 80 degrees Celsius for 4 hours. Power conversion efficiency measurements for devices containing filler materials showed average relative gains of 5.6% in efficiency and 2.8% in short circuit current density (Jsc) for mesa devices, and 3.8% in efficiency and 2.6% in Jsc for scribed devices, after controlling for annealing effects.

While only certain features of the invention have been illustrated and described herein, many modifications and changes will occur to those skilled in the art. It is, therefore, to be understood that the appended claims are intended to cover all such modifications and changes as fall within the true spirit of the invention.

Various aspects and embodiments of the present invention are defined by the following numbered clauses:
1. An article comprising:
   a photovoltaically active region; and
   a photovoltaically inactive region;
   wherein the article further comprises a filler material disposed in the inactive region, the filler material comprising a reflective material configured to scatter at least 50% of light incident on the filler material.
2. The article of clause 1, wherein the reflective material comprises a plurality of scattering centers disposed in a matrix.
3. The article of any preceding clause, wherein the scattering centers comprise voids.
4. The article of any preceding clause, wherein the voids have a median size of up to 1 micrometer.
5. The article of any preceding clause, wherein the scattering centers comprise particles.
6. The article of any preceding clause, wherein the particles comprise an inorganic material.
7. The article of any preceding clause, wherein the particles comprise an oxide.
8. The article of any preceding clause, wherein the particles comprise an oxide of titanium, aluminum, silicon, hafnium, zirconium, or combinations that include at least one of the foregoing.
9. The article of any preceding clause, wherein the particles have a median size of up to 10 micrometers.
10. The article of any preceding clause, wherein the particles have a median size in the range from about 200 nanometers to about 1000 nanometers.
11. The article of any preceding clause, wherein the matrix comprises a material selected from the group consisting of a glass, a polymer, or a hybrid organic-inorganic material.
12. The article of any preceding clause, wherein the difference between the index of refraction of the matrix and the index of refraction of the scattering centers is at least 0.01.
13. The article of any preceding clause, wherein the difference between the index of refraction of the matrix and the index of refraction of the scattering centers is at least 0.5.
14. The article of any preceding clause, wherein the scattering centers are in the matrix at a concentration in the range from about 10 volume percent to about 75 volume percent.
15. The article of any preceding clause, wherein the scattering centers are in the matrix at a concentration in the range from about 50 volume percent to about 70 volume percent.
16. The article of any preceding clause, wherein the filler material further comprises a passivating agent.
17. The article of any preceding clause, wherein the passivating agent comprises a sulfide or a halide compound.
18. The article of any preceding clause, wherein the filler material further comprises a wavelength converting material.
19. The article of any preceding clause, wherein the filler material comprises a first layer comprising the reflective material and a second layer comprising the wavelength converting material.
20. The article of any preceding clause, wherein the wavelength converting material comprises a plurality of particles in a matrix material.
21. The article of any preceding clause, wherein the particles comprise quantum-confined materials.
22. The article of any preceding clause, wherein the quantum-confined material comprises a quantum dot, a nanotube, or a nanowire.
23. The article of any preceding clause, wherein the wavelength converting material comprises an oxide, a fluoride, a phosphide, or an oxynitride.
24. The article of any preceding clause, wherein the wavelength converting material comprises a doped material comprising a luminescent dopant selected from the group consisting of erbium, samarium, manganese, cerium, and europium.
25. The article of any preceding clause, wherein the wavelength converting material has an excitation region that overlaps a low efficiency region of the active region.
26. The article of any preceding clause, wherein the wavelength converting material has an emission region that overlaps a high efficiency region of the active region.
27. The article of any preceding clause, wherein the active region comprises cadmium telluride, and wherein the wavelength converting material has an excitation region that includes one or more wavelengths of light less than about 600 nm.
28. The article of any preceding clause, wherein the active region comprises cadmium telluride, and wherein the wavelength converting material has an emission region that includes one or more wavelengths of light in the range from about 500 nm to about 850 nm.
29. The article of any preceding clause, wherein the active region comprises cadmium telluride, and wherein the wavelength converting material has an excitation region that includes one or more wavelengths of light less than about 600 nm and an emission region that includes one or more wavelengths of light in the range from about 500 nm to about 850 nm.
30. The article of any preceding clause, wherein the wavelength conversion material comprises an upconverting material.
31. The article of any preceding clause, wherein the upconverting material comprises a lanthanide-doped fluoride.
32. The article of any preceding clause, wherein the wavelength conversion material comprises a downconverting material.
33. The article of any preceding clause, wherein the downconverting material comprises barium aluminum fluoride doped with samarium.
34. The article of any preceding clause, wherein the downconverting material comprises aluminum oxide doped with chromium.
35. The article of any preceding clause, wherein the plurality of particles have a median size up to 10 micrometers.
36. The article of any preceding clause, wherein the plurality of particles has a median size in the range from about 200 nanometers to about 1000 nanometers.
37. The article of any preceding clause, wherein the inactive region comprises at least one area selected from the group consisting of a scribe line, an edge, and a gap between photovoltaic cells.
38. The article of any preceding clause, wherein the article comprises a plurality of inactive regions and the filler material is disposed in at least some of said inactive regions.
39. The article of any preceding clause, wherein the filler material disposed in at least one of the inactive regions further comprises an upconverting material, and the filler material disposed in at least one of the inactive regions further comprises a downconverting material.
40. An article comprising:
   a photovoltaically active region; and
   a photovoltaically inactive region;
   wherein the article further comprises a filler material disposed in the inactive region, the filler material comprising a wavelength converting material.
41. The article of any preceding clause, wherein the wavelength converting material comprises a plurality of particles in a matrix material.
42. The article of any preceding clause, wherein the particles comprise quantum-confined materials.
43. The article of any preceding clause, wherein the quantum-confined material comprises a quantum dot, a nanotube, or a nanowire.
44. The article of any preceding clause, wherein the wavelength converting material comprises an oxide, a fluoride, a phosphide, or an oxynitride.
45. The article of any preceding clause, wherein the wavelength converting material comprises a doped material comprising a luminescent dopant selected from the group consisting of erbium, samarium, manganese, cerium, and europium.
46. The article of any preceding clause, wherein the wavelength converting material has an excitation region that overlaps a low efficiency region of the active region.
47. The article of any preceding clause, wherein the wavelength converting material has an emission region that overlaps a high efficiency region of the active region.
48. The article of any preceding clause wherein the active region comprises cadmium telluride, and wherein the wavelength converting material has an excitation region that includes one or more wavelengths of light less than about 600 nm.
49. The article of any preceding clause, wherein the active region comprises cadmium telluride, and wherein the wavelength converting material has an emission region that includes one or more wavelengths of light in the range from about 500 nm to about 850 nm.
50. The article of any preceding clause, wherein the active region comprises cadmium telluride, and wherein the wavelength converting material has an excitation region that includes one or more wavelengths of light less than about 600 nm and an emission region that includes one or more wavelengths of light in the range from about 500 nm to about 850 nm.
51. The article of any preceding clause, wherein the wavelength conversion material comprises an upconverting material.
52. The article of any preceding clause, wherein the upconverting material comprises a lanthanide-doped fluoride.
53. The article of any preceding clause, wherein the wavelength conversion material comprises a downconverting material.
54. The article of any preceding clause, wherein the downconverting material comprises barium aluminum fluoride doped with samarium.
55. The article of any preceding clause, wherein the downconverting material comprises aluminum oxide doped with chromium.
56. The article of any preceding clause, wherein the plurality of particles have a median size up to 10 micrometers.
57. The article of any preceding clause, wherein the plurality of particles has a median size in the range from about 200 nanometers to about 1000 nanometers.
58. The article of any preceding clause, wherein the filler material further comprises a passivating agent.
59. The article of any preceding clause, wherein the passivating agent comprises a sulfide or a halide compound.
60. The article of any preceding clause, wherein the article comprises a plurality of inactive regions and the filler material is disposed in at least some of said inactive regions.
61. The article of any preceding clause, wherein the filler material disposed in at least one of the inactive regions further comprises an upconverting material, and the filler material disposed in at least one of the inactive regions further comprises a downconverting material.
62. An article comprising:
   a photovoltaically active region comprising cadmium telluride; and
   a photovoltaically inactive region;
   wherein the article further comprises a filler material disposed in the inactive region, the filler material comprising a wavelength converting material having an excitation region that includes light having a wavelength less than about 600 nm and an emission region that includes light having a wavelength in the range from about 500 nm to about 850 nm.

## Claims

1. An article (10) comprising:
a photovoltaically active region (20); and
a photovoltaically inactive region (30);
wherein the article (10) further comprises a filler material (40) disposed in the inactive region (30), the filler material (40) comprising a reflective material configured to scatter at least 50% of light incident on the filler material (40).

2. The article (10) of claim 1, wherein the reflective material comprises a plurality of scattering centers disposed in a matrix.

3. The article (10) of claim 2, wherein the scattering centers comprise a plurality of particles.

4. The article (10) of claim 3, wherein the particles comprise an oxide of titanium, aluminum, silicon, hafnium, zirconium, or combinations that include at least one of the foregoing.

5. The article (10) of claim 2 or claim 3, wherein the difference between the index of refraction of the matrix and the index of refraction of the scattering centers is at least 0.5.

6. The article (10) of any preceding claim, wherein the filler material (40) further comprises a passivating agent.

7. The article (10) of any preceding claim, wherein the filler material (40) further comprises a wavelength converting material.

8. The article (10) of claim 7, wherein the wavelength converting material comprises a plurality of particles in a matrix material.

9. The article (10) of claim 7 or claim 8, wherein the wavelength converting material comprises an oxide, a fluoride, a phosphide, or an oxynitride.

10. The article (10) of any of claims 7 to 9, wherein the wavelength converting material comprises a doped material comprising a luminescent dopant selected from the group consisting of erbium, samarium, manganese, cerium, and europium.

11. The article (10) of any of claims 7 to 10, wherein the wavelength converting material has an excitation region that overlaps a low efficiency region of the active region (20).

12. The article (10) of any of claims 7 to 11, wherein the wavelength converting material has an emission region that overlaps a high efficiency region of the active region (20).

13. The article (10) of any of claims 7 to 12, wherein the active region (20) comprises cadmium telluride, and wherein the wavelength converting material has an excitation region that includes one or more wavelengths of light less than about 600 nm and an emission region that includes one or more wavelengths of light in the range from about 500 nm to about 850 nm.

14. The article (10) of any preceding claim, wherein the inactive region (30) comprises at least one area selected from the group consisting of a scribe line, an edge, and a gap between photovoltaic cells.

15. An article (10) comprising:
a photovoltaically active region (20) comprising cadmium telluride; and
a photovoltaically inactive region (30);
wherein the article (10) further comprises a filler material (40) disposed in the inactive region (30), the filler material (40) comprising a wavelength converting material having an excitation region that includes light having a wavelength less than about 600 nm and an emission region that includes light having a wavelength in the range from about 500 nm to about 850 nm.
